# FASCICULE DE BREVET EUROPEEN

(11) **EP 3 390 685 B1**
(45) Date de publication et mention de la délivrance du brevet: **09.10.2019**
(21) Numéro de dépôt: 16819306.8
(22) Date de dépôt: 13.12.2016
(51) Int. Cl.: C23C 16/02, C23C 16/26, C23C 16/511, C23C 16/27, C30B 25/18, C30B 29/04

(54) **PROCÉDÉ DE PROTECTION D'UNE SURFACE MÉTALLIQUE D'UNE PIÈCE PAR UN REVÊTEMENT EN DIAMANT ET PIÈCE AINSI OBTENUE**
VERFAHREN ZUM SCHUTZ EINER METALLISCHEN OBERFLÄCHE EINES BAUTEILS MITTELS DIAMANTBESCHICHTUNG UND SO HERGESTELLTES TEIL
METHOD FOR PROTECTING A METAL SURFACE OF A PART BY A DIAMOND COATING AND PART THUS OBTAINED

(30) Priorité: 14.12.2015 FR 1562306
(43) Date de publication de la demande: 24.10.2018
(73) Titulaire: Commissariat à l'énergie atomique et aux énergies alternatives, 75015 Paris (FR)
(72) Inventeur: BERTHET, Guillaume, 78114 Magny-les-Hameaux (FR); SCORSONE, Emmanuel, 78114 Magny-les-Hameaux (FR)
(74) Mandataire: Brevalex
(86) Numéro de dépôt international: PCT/EP2016/080807
(87) Numéro de publication internationale: WO 2017/102734

(56) Documents cités:
- JP-A- 2009 091 234
- KROMKA A ET AL: "Seeding of polymer substrates for nanocrystalline diamond film growth", DIAMOND AND RELATED MATERIALS, ELSEVIER SCIENCE PUBLISHERS, AMSTERDAM, NL, vol. 18, no. 5-8, 1 mai 2009 (2009-05-01), pages 734-739, XP026155211, ISSN: 0925-9635, DOI: 10.1016/J.DIAMOND.2009.01.023 [extrait le 2009-01-21]
- HUGUES A. GIRARD ET AL: "Electrostatic Grafting of Diamond Nanoparticles: A Versatile Route to Nanocrystalline Diamond Thin Films", ACS APPLIED MATERIALS & INTERFACES, vol. 1, no. 12, 30 décembre 2009 (2009-12-30), pages 2738-2746, XP055173890, ISSN: 1944-8244, DOI: 10.1021/am900458g

## Description

### DOMAINE TECHNIQUE

Le domaine technique de l'invention est celui des revêtements de protection utilisés pour protéger des pièces métalliques évoluant dans des milieux sévères et donc sujettes à des conditions de haute pression pouvant s'élever jusqu'à 25 kpsi (2720 bar), de haute température jusqu'à typiquement 200°C, de corrosion et/ou d'abrasion.

Les domaines d'applications de la présente invention sont les pièces métalliques mécaniques, de structures ou de surface, destinées à évoluer dans des milieux sévères, en particuliers, mais non exclusivement, dans le domaine de l'aéronautique et des forages pétroliers.

### ÉTAT DE LA TECHNIQUE ANTÉRIEURE

Dans les domaines où les pièces métalliques sont soumises à des milieux sévères, la surface des pièces en contact avec ces milieux peuvent se détériorer et leurs propriétés physico-chimiques de surface être altérées au cours du temps, ce qui entraine des baisses de performances.

A titre d'exemple, les outils métalliques utilisés pour réaliser des forages pétroliers sont exposés à des conditions sévères : une pression supérieure à 1500 bars, une température supérieure à 150°C, une corrosion importante due à la forte teneur en sulfure d'hydrogène (H₂S) et une abrasion due aux gravats qui remontent à la surface ; leurs durées de vie optimales sont, de ce fait, extrêmement réduites et ils doivent être changés fréquemment.

De même, les capteurs à corps métalliques permettant d'analyser les différents fluides présents lors d'un forage pétrolier (eau salée, brut de pétrole, boues de forage, H₂S, CO₂, etc.) sont également soumis à ces conditions extrêmes. La détérioration de leurs propriétés physico-chimiques de surfaces entraine des baisses de performances et un vieillissement prématuré des capteurs, ainsi que des erreurs sur les mesures prises à l'aide de ces capteurs.

Afin de protéger la surface de ces pièces des détériorations provoquées par ces conditions extrêmes, il est possible de les revêtir d'une couche protectrice en diamant de synthèse.

Le diamant est un matériau présentant des propriétés physico-chimiques exceptionnelles, en particulier ses propriétés mécaniques et son inertie chimique.

Cependant, il est particulièrement difficile de faire croitre du diamant de synthèse sur un support ou substrat métallique. En outre, comme nous allons le voir ci-dessous, les couches de diamants déposées sur un support métallique présentent un manque d'adhésion, en particulier dans les milieux extrêmes tels que décrits ci-dessus.

Le dépôt de diamant de synthèse se fait généralement par la technique dite de dépôt chimique en phase vapeur assisté par plasma (ou plus simplement PACVD pour « *Plasma Assisted Chemical Vapor Deposition* »en anglais), le plasma comportant de l'hydrogène et une source de carbone, le plus souvent du méthane. Il existe plusieurs méthodes connues de l'homme du métier utilisant le dépôt PACVD, ces méthodes variant légèrement, en particulier en fonction de la source d'énergie utilisée pour créer le plasma (radiofréquence (RFCVD), micro-onde (MPACVD), filament chaud (HFCVD)).

Cependant, la technique de dépôt PACVD présente l'inconvénient de ne pas être compatible avec certains types de métaux, en particulier lorsque ces derniers comportent certains métaux de transition tels que le nickel, le fer, le cobalt ou des alliages de ces derniers. En effet, le nickel, le fer et le cobalt catalysent la formation du graphite au détriment de celle du diamant, empêchant ainsi la formation de cristaux de diamant.

De plus, les dépôts de diamant se font à une température généralement comprise entre 400°C et 1000°C. Or les coefficients de dilatation thermique des métaux sont généralement très supérieurs à celui du diamant. Ainsi, les variations de contraintes thermiques à l'interface diamant/métal empêchent l'adhésion des couches de diamant sur le métal.

Pour permettre une bonne adhésion d'une couche en diamant de synthèse sur un substrat métallique, y compris dans des conditions sévères, il y a donc deux problématiques à résoudre : d'une part, la problématique de la catalyse de formation du graphite par des métaux comme le nickel, cette catalyse empêchant la croissance de diamant sur les supports métalliques et, d'autre part, la problématique du manque d'adhésion lié à la fois au manque d'accroche chimique forte entre le diamant et le métal à l'interface, ainsi qu'aux différences importantes de dilatation thermique entre le métal et le diamant.

Dans le document **[1]**, les auteurs ont travaillé sur la faisabilité de déposer du diamant directement sur des aciers. Ils ont pour cela réalisé des croissances diamant à l'aide d'un réacteur HFCVD sur des substrats en acier, puis ils ont analysé le matériau obtenu à l'aide d'un microscope électronique à balayage (MEB) et d'un analyseur Raman. Ils ont été confronté au problème lié à la catalyse du carbone sous forme graphite par certains métaux contenus dans les aciers. Ils ont ainsi obtenus des matériaux de mauvaise qualité, contenant une majorité de carbone graphitique et donc peu de diamant. De tels matériaux sont inexploitables comme revêtements de protection.

De même, les auteurs du document **[2]** ont étudié la faisabilité de déposer du diamant sur de l'acier, sans déposer au préalable une sous couche métallique. Confrontés au même problème que dans le document **[1]**, les auteurs ont dû décomposer la croissance du diamant en plusieurs étapes. Dans un premier temps, ils profitent du phénomène de catalyse du graphite pour venir carburer la surface du substrat en acier, c'est-à-dire qu'ils vont venir déposer une couche de graphite sur la surface du substrat de manière à le saturer en carbone. Une fois cette couche déposée, ils refont une nouvelle croissance de diamant au-dessus de la couche graphitique. A cette étape, le substrat étant camouflé par le graphite, le diamant peut croitre sans risque que du carbone graphitique soit catalysé par l'acier. Bien que ces deux étapes soient effectuées dans un réacteur de croissance diamant MPACVD, cette méthode utilise bien une couche intermédiaire en graphite pour réaliser la croissance du diamant. Au final, étant donné que le graphite est un matériau potentiellement friable, il se trouve que, même si les résultats présentés par cette équipe semblent montrer une bonne adhésion de la couche diamant dans des conditions de températures et pressions ambiantes, l'adhésion de la couche de diamant sera fortement diminuée dans des conditions de plus hautes pressions et températures.

De manière générale, l'approche qui a été privilégiée dans l'art antérieur pour résoudre les deux problématiques de la catalyse de formation du graphite et du manque d'adhésion a été l'utilisation de couches intermédiaires entre le diamant et le substrat métallique. Le rôle de ces couches intermédiaires est, d'une part, de masquer le substrat métallique contenant le catalyseur (nickel, etc.) afin de stopper la formation du graphite et, d'autre part, de permettre la formation d'un carbure métallique à l'interface avec le diamant, afin de minimiser les contraintes thermiques et favoriser l'attache chimique du diamant sur le substrat métallique.

Dans la littérature, ces couches intermédiaires permettant la croissance du diamant sont souvent des couches nitrurées ou carbonitrurées (document **[3]**). Cependant, ces techniques mettant en oeuvre des couches intermédiaires sont souvent chronophages et couteuses à mettre en place puisqu'elles nécessitent l'utilisation d'un équipement supplémentaire, autre que celui nécessaire à la formation du diamant ; en outre, elles nécessitent que les couches intermédiaires aient une épaisseur supérieure au micromètre afin d'avoir un effet significatif sur les contraintes. Malheureusement, avec de telles épaisseurs, des contraintes peuvent aussi se former dans la couche intermédiaire elle-même, et poser des problèmes d'adhésion de cette couche intermédiaire sur le substrat métallique, avant même la croissance du diamant (document **[4]**). Enfin, la présence d'une couche intermédiaire épaisse peut entrainer des modifications non négligeables de la masse et de la géométrie de l'objet à protéger, ce qui peut s'avérer problématique lorsque la géométrie et la masse sont des paramètres critiques pour la métrologie de l'objet et qu'il est nécessaire de les faire varier le moins possible pour obtenir les meilleures performances.

Une autre méthode, qui consiste à rugosifier à une échelle de 0,1 à 10 micromètres la surface d'un empilement afin de réduire les contraintes dans le plan de l'empilement et ainsi améliorer l'adhérence globale au niveau de la ou des interfaces de l'empilement, est elle aussi souvent utilisée combinée avec l'utilisation d'une couche intermédiaire, afin d'améliorer l'adhérence de la couche intermédiaire sur un support métallique. Il est à noter que, souvent, cette méthode de rugosification n'est pas mise en avant dans les publications bien qu'elle soit utilisée, comme cela est observable sur les photographies à microscopie électronique à balayage (MEB). A titre d'illustration, on peut observer, sur les images présentant les résultats du procédé décrit dans le document **[2],** que les couches de graphite sont fortement rugueuses, ce qui doit contribuer à l'adhésion de la couche de diamant dans les conditions ambiantes. Cette méthode de rugosification ne peut cependant pas s'appliquer dans les cas, nombreux, où l'application finale de l'objet n'autorise pas de rugosifier sa surface. De plus les documents [6], [7] et [8] décrivent aussi des procédés similaires à l'invention avec formation d'une sous-couche par utilisation (pouvant être répétitive) d'une solution de particules de diamant nanométriques dans un solvant, séchage, puis croissance par CVD d'une couche de diamant.

Les inventeurs se sont donc fixé comme but de concevoir un procédé de formation d'un revêtement en diamant sur un substrat métallique qui ne comporte pas les inconvénients de l'art antérieur mentionnés ci-dessus.

### EXPOSÉ DE L'INVENTION

Ce but est atteint par un procédé de protection d'une surface métallique d'une pièce par un revêtement en diamant à gradient de porosité, ledit procédé comprenant les étapes suivantes :
a) la formation, sur la surface à protéger, d'un film de particules de diamant de tailles nanométriques, les particules étant agencées empilées les unes sur les autres en une pluralité de couches d'empilement successives, par la mise en oeuvre des opérations suivantes :
   i) la mise en contact de la surface métallique à protéger avec une solution colloïdale contenant des particules de diamant de tailles nanométriques dispersées dans un solvant ; et
   ii) l'élimination du solvant par séchage, moyennant quoi on obtient une couche d'empilement ;
   l'enchainement desdites opérations i) et ii) étant répété plusieurs fois de suite, de préférence au moins quatre fois ;
b) la formation du revêtement en diamant par croissance de diamant à partir des nanoparticules du film formé à l'étape a), la croissance étant réalisée par dépôt chimique en phase vapeur assisté par plasma dans des conditions permettant l'obtention d'un revêtement en diamant ayant une face interne et une face externe, et comportant un gradient de porosité croissant de la face externe vers la face interne.

La mise en contact peut consister en une enduction centrifuge en utilisant une tournette (dépôt à la tournette ou « spin coating » en anglais), une pulvérisation, un dépôt à la goutte, un trempage-retrait (« dip coating » en anglais), etc. toutes ces techniques de dépôt étant bien connues de l'homme du métier.

De préférence, le revêtement en diamant obtenu à l'issue de l'étape b) résiste à une pression d'au moins 200 bars.

Afin de réaliser le revêtement en diamant selon l'invention, nous avons besoin de maîtriser deux étapes essentielles.

La première étape (étape a), préalable à la formation du revêtement en diamant, est la formation d'un film de nanoparticules de diamant sur la surface à protéger. Plusieurs techniques existent à ce jour et sont utilisées par les hommes du métier pour amorcer la croissance de couches de diamant de synthèse sur un support. Il est cependant nécessaire d'adapter les techniques connues à notre problématique, de manière à obtenir un film de nanoparticules dans lequel les particules sont réparties de façon homogène en couches d'empilement successives, de sorte à recouvrir l'ensemble de la surface à protéger. Le fait que le film de particules comprenne plusieurs couches d'empilement implique que le taux de particules déposé sera suffisamment important pour recouvrir totalement la surface à recouvrir. De préférence, la densité de particules dans le film formé à l'étape a) est d'au moins 10¹⁰ particules/cm². En outre, du fait de la pluralité de couches d'empilement, on obtient un film de particules qui est épais, ce qui va permettre d'empêcher la formation de graphite à l'interface avec la surface à protéger, puisque les couches d'empilement du film de particules vont protéger (en la masquant) la surface métallique d'une exposition importante aux espèces réactives du plasma au cours de la croissance à l'étape b) (et cet accès des espèces réactives du plasma à l'interface sera de plus en plus limité au fur et à mesure de la coalescence des particules).

La seconde étape (étape b) consiste à faire coalescer les particules de diamants entre elles, c'est-à-dire de faire croitre les particules de diamant (cristaux de dimensions nanométriques) jusqu'à créer des liaisons chimiques fortes à la jonction des particules. Plus les particules sont proche de la face externe du film, plus elles vont croitre rapidement. En effet, les particules de diamant situées en surface vont croitre plus rapidement que les particules de diamant situées en profondeur, car la pénétration des espèces réactives dans le plasma est limitée par la diffusion à travers le film de particules.

Il s'agit donc ici de trouver un compromis dans les conditions de croissance pour que, d'une part, les particules situées dans les couches d'empilement supérieures du film ne croissent pas trop vite, ce qui empêcherait la croissance des particules situées dans les couches d'empilement inférieures du film et donc entraînerait un manque d'adhésion du revêtement, et pour que, d'autre part, les particules des couches d'empilement inférieures ne croissent pas trop, ce qui viendrait, à l'extrême, à boucher le vide entre les particules et donc accroitre les contraintes dans le revêtement. En fait, le dépôt chimique en phase vapeur assisté par plasma est réalisé à l'étape b) dans des conditions permettant une coalescence des particules différente d'une couche d'empilement à une autre.

Au final, on obtient un revêtement en diamant qui comporte une porosité qui est croissante au fur et à mesure que l'on se rapproche de l'interface avec la surface à protéger. La présence de vide à l'interface du fait de la porosité permet d'absorber les contraintes du revêtement en diamant, ce qui favorise fortement son adhésion sur la surface métallique.

Avant d'entrer plus en détails dans l'exposé de l'invention, nous précisons les définitions suivantes.

Dans ce qui précède et ce qui suit, le terme « taille », appliqué à des particules, désigne la plus grande dimension de ces particules; le terme « nanométrique » signifie supérieur ou égal à 1 nanomètre et inférieur ou égal à 100 nanomètres ; le terme « nanoparticules » désigne des particules de tailles nanométriques.

On rappelle par ailleurs que le terme « particule » désigne un élément dont le rapport de la plus grande dimension sur la plus petite dimension est inférieur ou égal à 10. Généralement, les particules seront essentiellement sphériques.

Enfin, on entend par « couches d'empilement » des couches de particules empilées dans le sens de l'épaisseur du film formé à l'étape a). On peut également parler de niveaux d'empilement.

Selon un mode de réalisation préféré de l'invention, l'étape a) comprend en outre, avant l'opération i), une opération h) de dépôt, sur la surface à protéger, d'une couche d'un polymère chargé positivement ou négativement, et l'opération i) consiste en une mise en contact de la couche de polymère avec une solution colloïdale contenant des particules de diamant de tailles nanométriques ayant une charge électrique opposée à celle du polymère et dispersées dans un solvant, l'enchainement des opérations h), i) et ii) étant répété plusieurs fois de suite, de préférence au moins quatre fois. Ce mode de réalisation présente l'avantage d'être simple à mettre en place et ne nécessite pas d'équipement lourd, ni de personnel qualifié.

Avantageusement, l'étape a) comprend en outre, après l'opération ii) d'élimination du solvant, et avant la répétition de l'enchainement des opérations i) et ii) ou de l'enchainement des opérations h), i) et ii), une opération de croissance de diamant à partir des nanoparticules de la couche d'empilement obtenue à l'issue de l'opération ii), la croissance étant réalisée par dépôt chimique en phase vapeur assisté par plasma dans des conditions permettant l'obtention d'une coalescence partielle des nanoparticules de ladite couche d'empilement. Cela permet de fixer les nanoparticules les unes aux autres et améliorer l'adhérence du revêtement final.

Avantageusement, l'opération de croissance de diamant à l'étape a) est réalisée à une pression comprise entre 2 et 30 mbar et à une température de la pièce à revêtir comprise entre 200 et 400°C.

De préférence, la croissance à l'étape b) est réalisée jusqu'à obtenir une coalescence maximale des particules de la dernière couche d'empilement du film de particules et une coalescence partielle des particules de la première couche d'empilement du film de particules, de manière à obtenir un revêtement ayant un gradient de porosité, mais étant continu en surface. En d'autres termes, la croissance est telle que les nanoparticules en surface ont coalescées jusqu'à former une face externe continue, tandis que les nanoparticules à proximité de l'interface avec la surface à protéger (c'est-à-dire au niveau de la face interne du film de particules) n'ont que partiellement coalescé (il reste des espaces entre les particules). On obtient ainsi un revêtement en diamant ayant une porosité nulle ou quasi-nulle en surface (revêtement continu en surface) et une porosité qui augmente au fur et à mesure que l'on se rapproche de l'interface avec la surface métallique.

De préférence, le revêtement en diamant obtenu à l'issue de l'étape b) a, au niveau de sa face externe, une porosité inférieure à 0,1% du volume total du revêtement en diamant, et qui est de préférence nulle.

De préférence, le revêtement en diamant obtenu à l'issue de l'étape b) a une porosité maximale au niveau de sa face interne, ladite porosité maximale correspondant à 0,1 à 10% du volume total du revêtement en diamant.

Selon un mode de réalisation préféré de l'invention, la croissance à l'étape b) est réalisée à une pression comprise entre 2 et 30 mbar et à une température de la pièce à recouvrir comprise entre 200°C et 400°C. Dans ces conditions, la vitesse de croissance est très lente (entre 1 et 10 nm par heure), ce qui permet un bon contrôle de la croissance et, en particulier, de ne pas faire sur-croitre les nanoparticules des couches supérieures de l'empilement. L'objectif de cette croissance est de ne faire croitre les nanoparticules de diamant que très peu, typiquement entre 1 et 20 nm. Il est à noter que la pression et la puissance micro-onde utilisée pour créer le plasma vont jouer sur la température de la pièce à recouvrir et il ne faut pas confondre la température de la pièce à recouvrir et la température du plasma. On peut tout à fait utiliser une température du plasma supérieure à 400°C, ce qui nous aide à obtenir un diamant de bonne qualité, mais afin que la température de la pièce à recouvrir ne dépasse pas 400°C, on fera alors en sorte de stopper la croissance avant que température de la pièce ne dépasse cette valeur. C'est la raison pour laquelle il est tout à fait possible d'utiliser une température de plasma supérieure à 400°C, à condition toutefois de diminuer la durée de la croissance (durée inférieure à 45 minutes).

De préférence, la croissance à l'étape b) est réalisée dans un réacteur MPACVD.

Avantageusement, le film de particules formé à l'étape a) comporte au moins quatre couches d'empilement. Les particules de diamant ayant généralement un diamètre compris entre 5 et 100 nm, le film de particules formé à l'étape a) pourra avoir une épaisseur minimale comprise entre 20 nm (si l'on utilise des particules de 5 nm de diamètre) et 400 nm (si l'on utilise des particules de 100 nm de diamètre).

Avantageusement, le film de particules formé à l'étape a) a une épaisseur comprise entre 20 nm et 2 µm.

En ce qui concerne l'épaisseur du revêtement en diamant obtenu à l'issue de l'étape b), elle dépend de la taille des particules utilisées pour former le film de particules à l'étape a), ainsi que de la durée de la croissance à l'étape b).

La face interne du revêtement en diamant obtenu à l'issue de l'étape b) peut être directement en contact avec la surface métallique de la pièce à protéger. En d'autres termes, la première couche d'empilement du film de particules formé à l'étape a) peut être directement en contact avec la surface métallique à protéger et, au final, il n'y a pas de couche intermédiaire disposée entre la surface métallique et le revêtement en diamant.

L'invention concerne également une pièce comportant un substrat métallique ayant une surface recouverte d'un revêtement en diamant, caractérisée en ce que le revêtement en diamant est obtenu par la mise en oeuvre du procédé de protection tel que décrit ci-dessus.

Le substrat métallique peut former le corps de la pièce. Il peut également former un revêtement de surface disposé sur un corps non métallique. Le substrat métallique est en un matériau métallique tel qu'un métal ou un alliage métallique ; il peut par exemple s'agir d'un matériau corrodable, tel qu'un acier ou un alliage de nickel.

La pièce peut, par exemple, être un outil de perçage ou de découpe, un capteur de mesure, un actionneur, etc. utilisable dans de nombreux domaines d'application, et notamment dans le domaine des forages pétroliers, gaziers ou géothermiques.

Le procédé objet de l'invention est particulièrement intéressant, car il permet d'obtenir une couche de diamant directement sur la surface d'un substrat métallique, sans nécessiter de prétraitement particulier de cette surface. En particulier, le procédé selon l'invention permet de réaliser une couche de diamant sur un substrat métallique présentant n'importe quel type de topologie de surface (rugueuse ou lisse).

Par ailleurs, le procédé ne nécessite pas non plus de la présence d'une couche intermédiaire entre le substrat et la couche de diamant pour permettre l'adhérence de la couche de diamant sur le substrat.

Enfin, il permet d'améliorer les propriétés physico-chimiques de surface du substrat métallique telle que la mouillabilité ou la friction, puisque le diamant est en effet connu pour ses propriétés de grande inertie chimique, ses propriétés mécaniques exceptionnelles et enfin ses propriétés de chimie de surface (par exemple, hydrophile ou hydrophobe) intéressantes.

Le procédé selon l'invention peut être appliqué dans tout domaine nécessitant la formation d'un revêtement de protection en diamant sur une pièce métallique, ce revêtement pouvant servir de protection contre la corrosion, l'encrassement et/ou l'abrasion. A titre d'exemple, ce procédé peut être appliqué dans le domaine pétrolier, notamment sur les outils de forage, mais également dans le domaine maritime, des capteurs, du nucléaire, etc.

D'autres caractéristiques et avantages de l'invention apparaîtront mieux à la lecture du complément de description qui suit et qui se réfère aux figures annexées.

### BRÈVE DESCRIPTION DES DESSINS

Les figures 1a et 1b sont des représentations schématiques selon une vue en coupe d'un substrat métallique à deux stades différents du procédé objet de l'invention, à savoir lorsqu'il comporte un film de nanoparticules de diamant sur une de ses surfaces (figure la) et à l'issue de la croissance des nanoparticules de diamant, la surface du substrat étant recouverte d'une couche de diamant ayant un gradient de porosité (figure 1b).
La figure 2 est une image obtenue par microscopie électronique à balayage (MEB) de la surface d'un substrat métallique recouvert d'une couche de diamant (échantillon 1), obtenue selon un mode de réalisation du procédé objet de l'invention.
La figure 3 est une image obtenue par microscopie électronique à balayage de la surface d'un substrat métallique recouvert d'une couche de diamant dopé au bore (échantillon 2), obtenue selon un autre mode de réalisation du procédé objet de l'invention.
La figure 4 est une image obtenue par microscopie électronique à balayage de la surface du substrat métallique recouvert d'une couche de diamant (échantillon 1), après que cet échantillon ait subi des tests d'adhérence à haute pression et à haute température.

### EXPOSÉ DÉTAILLÉ DE MODES DE RÉALISATION PARTICULIERS

Le procédé objet de l'invention permet de revêtir une surface d'une pièce métallique, par exemple les parties sensibles d'un capteur, d'une couche protectrice en diamant de synthèse. Ce procédé permet d'obtenir une couche de diamant qui est couvrante et fortement adhérente. Le revêtement ainsi obtenu offre à la fois une protection face aux conditions sévères, mais améliore aussi les propriétés de surface telle que la mouillabilité.

Comme nous l'avons décrit précédemment, il existe deux problèmes liés à la croissance de diamant sur des substrats métalliques : le phénomène de catalyse du carbone sous forme graphite en présence de métaux de transition lors de la croissance PACVD et la différence de coefficient de dilatation thermique entre les métaux et le diamant.

Pour illustrer le procédé objet de l'invention, nous avons utilisé comme support métallique un acier inoxydable appelé « inconel™ 718 », qui présente la composition chimique suivante :

| Elément (% massique) | | | | | | | |
|---|---|---|---|---|---|---|---|
| Ni | Cr | Fe | Mo | Nb | Co | Mn | Cu |
| 50,0 - 55,0 | 17,0 - 21,0 | qsp 100 % | 2,80 - 3,30 | 4,75 - 5,50 | 1,0 max | 0,35 max | 0,30 max |
| Al | Ti | Si | C | S | P | B | |
| 0,20 - 0,80 | 0,65 - 1,15 | 0,35 max | 0,08 max | 0,015 max | 0,015 max | 0,006 max | |

Dans le cas de l'inconel™ 718, nous sommes confrontés à ces deux problèmes, car cet alliage contient de 50 à 55% en poids de nickel et la différence de coefficient de dilatation thermique entre l'inconel™ 718 et le diamant est très importante (les coefficients de dilation thermique de l'inconel™ 718 et du diamant étant respectivement de 13.10⁶K⁻¹ et de 1.10⁶K⁻¹ à 25°C, cette différence est égale à 12.10⁶K⁻¹ à 25°C).

Le substrat d'inconel™ 718 utilisé est un substrat plan ayant comme dimensions 1 x 1 x 0,3 cm³.

La première étape du procédé selon l'invention consiste à déposer des particules 3 de diamant de tailles nanométriques sur la surface du substrat 1, les particules étant empilées les unes sur les autres en couches d'empilement 4 successives, l'ensemble formant une couche 2 de particules (figure la).

Il existe de nombreuses techniques de dépôt de nanoparticules de diamant dans la littérature. Dans le cadre de la présente invention, il n'y a pas de contraintes sur le choix de la technique de dépôt à partir du moment où celle-ci permet d'obtenir une forte densité de nanoparticules de diamant sur le substrat de manière à pouvoir obtenir une couche couvrante (on entend par « forte densité » une densité supérieure ou égale à 10¹⁰ particules/cm²). Par exemple, il est possible de procéder au dépôt par pulvérisation à partir d'une solution colloïdale de nanoparticules de diamant, puis au séchage, ou encore au dépôt à la tournette à partir s'une solution comportant des nanoparticules de diamant, puis au séchage, ou encore au dépôt d'un liquide (par exemple sous forme de gouttes) comportant les nanoparticules de diamant directement sur le substrat, puis au séchage.

Il est à noter que cette étape de dépôt de nanoparticules de diamant sur le substrat est répétée plusieurs fois, de manière à obtenir une couche couvrante plus épaisse comportant plusieurs couches d'empilement successives.

La méthode préférée est celle du dépôt dit « couche par couche » tel que décrite dans le document **[5]**). Elle consiste à tremper le substrat dans une solution contenant un polymère dissout comportant une charge positive (par exemple, le Poly-diallyldimethylammonium chloride ou PDDAC) ou négative (par exemple, le Poly(styrène sulfonate) de sodium). Après trempage, rinçage et éventuellement séchage, une fine couche de polymère est déposée sur la surface du substrat. Ensuite, cette surface est plongée dans une solution colloïdale de particules de diamant comportant des particules de diamant présentant une charge opposée à celle du polymère déposé et dispersées dans un solvant (par exemple de l'eau) et on procède ensuite au séchage pour éliminer le solvant. Ainsi, par attractions électrostatiques, les particules de diamant vont venir se déposer sur le substrat.

Les particules de diamant utilisées peuvent être des particules obtenues par broyage de diamant ou par détonation.

Dans notre exemple de réalisation, nous avons choisi de tremper le substrat d'inconel™ 718 dans une solution aqueuse contenant 1% en masse de PDDAC pendant environ 20 minutes. Le substrat est ensuite rincé à l'eau, puis trempé dans une solution colloïdale aqueuse contenant des nanoparticules de diamant (ici, des particules de broyage de 20 nm de diamètre (référence SYNDIA20 de chez Van Moppes, Suisse). Pour obtenir un taux de recouvrement satisfaisant, il est préférable d'utiliser une solution fortement concentré en nanoparticules de diamant (c'est-à-dire une concentration d'environ 1 g/L), pendant une durée assez longue (c'est-à-dire environ 4 heures), de manière à saturer la surface en nanoparticules de diamant. L'objectif de cette étape est de recouvrir entièrement le substrat de particules de diamant. Ces étapes ont été réalisées 4 fois de suite.

Cette première étape, si elle est réalisée par trempage en solution aqueuse, peut présenter une difficulté particulière sur certains substrats métalliques qui se corrodent rapidement en solution aqueuse et qui peuvent donc être détériorés au cours de cette étape. Dans ce cas, on préférera utiliser une technique de dépôt de nanoparticules sans trempage en solution aqueuse, par exemple la technique de pulvérisation en utilisant un solvant non corrosif.

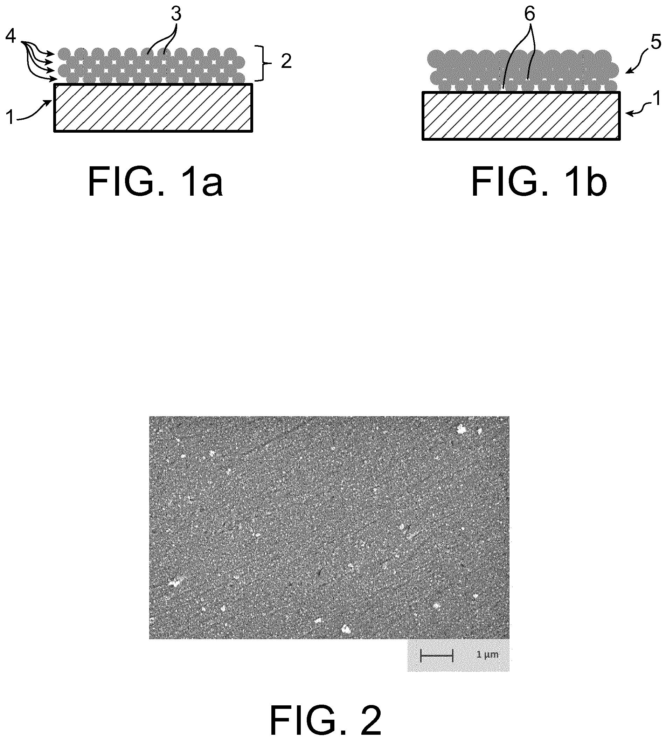

La seconde étape consiste à faire croitre les nanoparticules de diamant jusqu'à provoquer la coalescence des nanoparticules entre elles. Nous utilisons un réacteur de croissance CVD assisté par plasma (PACVD), le plasma pouvant être produit par micro-ondes, par radiofréquences ou par filament chaud. Au final, on obtient un revêtement 5 de diamant polycristallin, c'est-à-dire un assemblage de cristaux de diamant coalescés reliés entre eux par des joints de grain, ce revêtement étant continu en surface et comportant une porosité 6 à proximité de l'interface diamant/substrat métallique (figure 1b).

Dans notre exemple de réalisation, nous avons utilisé un réacteur CVD de croissance diamant assisté par plasma micro-ondes, à savoir le réacteur de la société SEKI Technotron portant la référence AX6500X. La croissance du diamant se fait généralement en présence d'hydrogène et d'une source de carbone, par exemple le méthane. Une source de bore peut aussi être ajoutée dans la phase gaz, par exemple à partir de diborane ou de triméthylbore, pour permettre le dopage de la couche de diamant.

Dans le cadre de la présente invention, les conditions de fonctionnement du réacteur CVD doivent être adaptées par rapport aux conditions classiques de croissance du diamant, bien connues des experts du domaine de la croissance de diamant synthétique.

En particulier, la croissance du diamant, qui est généralement réalisée, dans l'art antérieur, à une température comprise typiquement entre 500 et 1000°C et pendant une durée de plusieurs heures, a ici été réalisée dans des conditions de très basses pressions (typiquement entre 2 et 30 mbar) et de très basses températures du substrat (entre 200 et 400°C). Alternativement, des conditions de température et de pression plus élevées peuvent très utilisés à condition de limiter le temps de croissance à des temps très courts (typiquement inférieurs à 30 minutes).

Dans notre exemple de réalisation, nous avons réalisé, sur un premier substrat, une couche de diamant (échantillon 1) et, sur un second substrat, une couche de diamant dopé au bore (échantillon 2). Les premier et second substrats sont de l'inconel™ 718 ayant un film de nanoparticules de diamant préparé tel que décrit ci-dessus.

La croissance d'un revêtement de diamant, dopé ou non au bore, sur le substrat est obtenue en plaçant le substrat ainsi préparé dans le réacteur CVD et en appliquant les paramètres de croissance suivants :
- pression : 10 Torr (environ 13,33 mbar) ;
- température du substrat : 300°C ;
- puissance des micro-ondes : 470 W ;
- CH₄/H₂ : 1 %/99%, pour l'échantillon 1 ;
- CH₄/H₂/B(CH₃)₃ : 1%/98,9 %/0,1 %, pour l'échantillon 2 ;
- durée : 45 minutes.

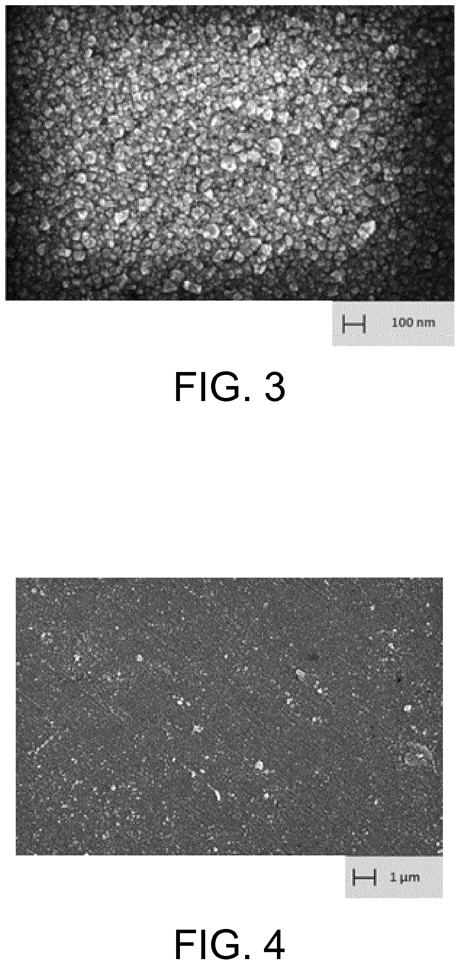

Des images enregistrées au microscope électronique à balayage des revêtements de diamant ainsi obtenus sont présentées dans la figure 2 (échantillon 1) et la figure 3 (échantillon 2). Pour ces deux échantillons, la rugosité de la surface du revêtement en fin de procédé a été estimée à environ 20 nm en valeur efficace.

Des tests d'adhérence à haute pression (1800 bars) et à haute température (175°C) ont été réalisés sur les deux échantillons. On a ainsi pu constater en observant le revêtement par imagerie MEB que celui-ci avait bien résisté aux tests en pression et en température. Dans la figure 4 représentant une image MEB de l'échantillon 1 après les tests d'adhérences, on constate en effet que le revêtement en diamant est toujours présent et couvrant.

### REFERENCES CITEES

**[1]** Buijnsters J. G. et al. « Direct deposition of polycrystalline diamond onto steel substrates », Surface & Coatings Technology 201 (2007), pages 8955-8960
**[2]** Gowri, M. et al. « Direct deposition of diamond films on steel using a three-step process », Diamond & Related Materials 15 (2006), pages 498-501
**[3]** Fayer A. et al. « Deposition of continuous and well adhering diamond films on steel », Applied Physics Letters 67 (1995), pages 2299-2301
**[4]** Haubner et al. « Diamond deposition on steel substrates using intermediate layers ». International Journal of Refractory Metals & Hard Materials 24 (2006), pages 380-386
**[5]** Girard U. et al. « Electrostatic grafting of diamond nanoparticles: a versatile route to nanocrystalline diamond thin films », Applied Materials & Interfaces, vol. 1, n°12 (2009), pages 2738-3746
[6] Kromka A. et al. "Seeding of polymer substrates for nanocrystalline diamond film growth", DIAMOND AND RELATED MATERIALS, vol. 18, N°5-8 (2009), pages 734-739.
[7] Hugues A. et al. "Electrostatic Grafting of Diamond Nanoparticles: A Versatile Route to Nanocrystalline Diamond Thin Films", ACS Applied Materials & Interfaces, vol. 1, n°12 (2009), pages 2738-2746.
[8] Girard H A. et al. "Electrostatic grafting of diamond nanoparticles towards 3D diamond nanostructures", DIAMOND AND RELATED MATERIALS, vol. 23 (2012), pages 83-87

## Revendications

1. Procédé pour améliorer l'adhérence d'un revêtement en diamant (5) sur une surface métallique d'une pièce (1), ledit procédé comprenant les étapes suivantes :
a) la formation, sur la surface à protéger, d'un film (2) de particules de diamant de tailles nanométriques (3) ;
b) la formation du revêtement en diamant (5) par croissance de diamant à partir des nanoparticules (3) du film (2), la croissance étant réalisée par dépôt chimique en phase vapeur assisté par plasma ;
le procédé étant **caractérisé en ce que**, dans le film (2) de particules de diamant de tailles nanométriques (3) obtenu à l'étape a), les particules sont agencées empilées les unes sur les autres en une pluralité de couches d'empilement (4) successives, le film étant obtenu par la mise en oeuvre des opérations suivantes :
i) la mise en contact de la surface métallique à protéger avec une solution colloïdale contenant des particules de diamant de tailles nanométriques dispersées dans un solvant ; et
ii) l'élimination du solvant par séchage, moyennant quoi on obtient une couche d'empilement ;
l'enchainement desdites opérations i) et ii) étant répété plusieurs fois de suite, de préférence au moins quatre fois ;
et le procédé étant **caractérisé en ce que**, à l'étape b), la croissance de diamant à partir des nanoparticules (3) du film (2) est réalisée par dépôt chimique en phase vapeur assisté par plasma dans des conditions permettant une croissance des nanoparticules de 1 à 20 nm, en utilisant une pression comprise entre 2 et 30 mbar et une température de la pièce à revêtir comprise entre 200 et 400°C, moyennant quoi on obtient un revêtement en diamant ayant une face interne et une face externe, et comportant un gradient de porosité (6) croissant de la face externe vers la face interne.

2. Procédé selon la revendication 1, dans lequel l'étape a) comprend en outre, avant l'opération i), une opération h) de dépôt, sur la surface à protéger, d'une couche d'un polymère chargé positivement ou négativement, et l'opération i) consiste en une mise en contact de la couche de polymère avec une solution colloïdale contenant des particules de diamant de tailles nanométriques ayant une charge électrique opposée à celle du polymère et dispersées dans un solvant, l'enchainement des opérations h), i) et ii) étant répété plusieurs fois de suite, de préférence au moins quatre fois.

3. Procédé selon la revendication 1 ou la revendication 2, dans lequel l'étape a) comprend en outre, après l'opération ii) d'élimination du solvant, et avant la répétition de l'enchainement des opérations i) et ii), une opération de croissance de diamant à partir des nanoparticules (3) de la couche d'empilement obtenue à l'issue de l'opération ii), la croissance étant réalisée par dépôt chimique en phase vapeur assisté par plasma dans des conditions permettant l'obtention d'une coalescence partielle des nanoparticules de ladite couche d'empilement.

4. Procédé selon la revendication 3, dans lequel l'opération de croissance de diamant à l'étape a) est réalisée à une pression comprise entre 2 et 30 mbar et à une température de la pièce à revêtir comprise entre 200 et 400°C.

5. Procédé selon l'une quelconque des revendications 1 à 4, dans lequel le revêtement en diamant obtenu à l'issue de l'étape b) a, au niveau de sa face externe, une porosité inférieure à 0,1% du volume total du revêtement en diamant, et qui est de préférence nulle.

6. Procédé selon l'une quelconque des revendications 1 à 5, dans lequel le revêtement en diamant obtenu à l'issue de l'étape b) a une porosité maximale au niveau de sa face interne, ladite porosité maximale correspondant à 0,1 à 10% du volume total du revêtement en diamant.

7. Procédé selon l'une quelconque des revendications 1 à 6, dans lequel le film de particules formé à l'étape a) comporte au moins quatre couches d'empilement.

8. Procédé selon l'une quelconque des revendications 1 à 7, dans lequel le film de particules formé à l'étape a) a une épaisseur comprise entre 20 nm et 2 µm.

9. Procédé selon l'une quelconque des revendications 1 à 8, dans lequel la face interne du revêtement en diamant obtenu à l'issue de l'étape b) est directement en contact avec la surface métallique de la pièce à protéger.

10. Pièce (1) comportant un substrat métallique ayant une surface recouverte d'un revêtement en diamant (2), **caractérisée en ce que** le revêtement en diamant est obtenu par la mise en oeuvre du procédé tel que défini dans l'une quelconque des revendications 1 à 9.

11. Pièce (1) selon la revendication 10, dans laquelle le revêtement en diamant a, au niveau de sa face externe, une porosité inférieure à 0,1% du volume total du revêtement en diamant, et qui est de préférence nulle.

12. Pièce (1) selon la revendication 10 ou 11, dans laquelle le revêtement en diamant a une porosité maximale au niveau de sa face interne, ladite porosité maximale correspondant à 0,1 à 10% du volume total du revêtement en diamant.

## Patentansprüche

1. Verfahren zum Verbessern der Haftung einer Beschichtung aus Diamant (5) auf einer metallischen Oberfläche eines Gegenstands (1), wobei das Verfahren die folgenden Schritte umfasst:
a) Bilden eines Films (2) aus Diamantpartikeln mit Nanometer-Abmessungen (3) auf der zu schützenden Oberfläche;
b) Bilden der Beschichtung aus Diamant (5) durch Wachsen von Diamant ausgehend von den Nanopartikeln (3) des Films (2), wobei das Wachsen durch chemisches Abscheiden aus der Dampfphase unterstützt durch Plasma durchgeführt wird;
wobei das Verfahren **dadurch gekennzeichnet ist, dass** in dem Film (2) aus Diamantpartikeln mit Nanometer-Abmessungen (3), welcher in Schritt a) erhalten wird, die Partikel aufeinander gestapelt in einer Mehrzahl von aufeinander folgenden Stapelschichten (4) angeordnet sind, wobei der Film durch das Ausführen der folgenden Vorgänge erhalten wird:
i) in-Kontakt-Bringen der zu schützenden metallischen Oberfläche mit einer kolloidalen Lösung, welche Diamantpartikel mit Nanometer-Abmessungen enthält, welche in einem Lösungsmittel verteilt sind; und
ii) Beseitigen des Lösungsmittels durch Trocknung, wodurch eine Stapelschicht erhalten wird;
wobei die Abfolge der Vorgänge i) und il) mehrmals nacheinander wiederholt wird, vorzugsweise wenigstens viermal;
und wobei das Verfahren **dadurch gekennzeichnet ist, dass** in Schritt b) das Wachsen von Diamant ausgehend von den Nanopartikeln (3) des Films (2) durch chemisches Abscheiden aus der Dampfphase unterstützt von Plasma unter Bedingungen durchgeführt wird, welche ein Wachsen der Nanopartikel von 1 bis 20 nm erlauben, indem ein Druck, welcher zwischen 2 und 30 mbar beträgt, und eine Temperatur des zu beschichteten Gegenstands verwendet wird, welche zwischen 200 und 400°C beträgt, wodurch eine Beschichtung aus Diamant erhalten wird, welche eine innere Fläche und eine äußere Fläche aufweist, sowie einen Porositätsgradienten (6), welcher von der äußeren Fläche in Richtung der inneren Fläche anwächst.

2. Verfahren nach Anspruch 1, wobei der Schritt a) ferner vor dem Vorgang i) einen Vorgang h) eines Abscheidens einer positiv oder negativ geladenen Polymerschicht auf der zu schützenden Oberfläche umfasst, und der Vorgang i) aus einem in-Kontakt-Bringen der Polymerschicht mit einer kolloidalen Lösung besteht, welche Diamantpartikel mit Nanomater-Abmessungen enthält, welche eine entgegengesetzte elektrische Ladung zu derjenigen des Polymers aufweisen und in einem Lösungsmittel verteilt sind, wobei die Abfolgen der Vorgänge h), i) und ii) mehrmals nacheinander durchgeführt werden, vorzugsweise wenigstens viermal.

3. Verfahren nach Anspruch 1 oder Anspruch 2, wobei der Schritt a) ferner nach dem Vorgang ii) des Beseitigens des Lösungsmittels und vor der Wiederholung der Abfolge der Vorgänge i) und ii) einen Vorgang eines Wachsens von Diamant ausgehend von den Nanopartikeln (3) der Stapelschicht umfasst, welche beim Abschluss des Schritts ii) erhalten werden, wobei das Wachsen durch chemisches Abscheiden aus der Dampfphase unterstützt von Plasma unter Bedingungen durchgeführt wird, welche das Erhalten eines teilweisen Verwachsens von Nanopartikeln der Stapelschicht erlauben.

4. Verfahren nach Anspruch 3, wobei der Vorgang des Wachsens von Diamant in dem Schritt a) bei einem Druck, welcher zwischen 2 und 30 mbar beträgt, und einer Temperatur des zu beschichtenden Gegenstands durchgeführt wird, welche zwischen 200 und 400°C beträgt.

5. Verfahren nach einem der Ansprüche 1 bis 4, wobei die Beschichtung aus Diamant, welche beim Abschluss des Schritts b) erhalten wird, auf dem Niveau ihrer äußeren Fläche eine Porosität aufweist, welche kleiner als 0,1% des Gesamtvolumens der Beschichtung aus Diamant ist, und die vorzugsweise null ist.

6. Verfahren nach einem der Ansprüche 1 bis 5, wobei die Beschichtung aus Diamant, welche beim Abschluss des Schritts b) erhalten wird, eine maximale Porosität auf dem Niveau ihrer inneren Fläche aufweist, wobei die maximale Porosität 0,1 bis 10% des Gesamtvolumens der Beschichtung aus Diamant entspricht.

7. Verfahren nach einem der Ansprüche 1 bis 6, wobei der Film aus Partikeln, welcher in Schritt a) gebildet wird, wenigstens vier Stapelschichten umfasst.

8. Verfahren nach einem der Ansprüche 1 bis 7, wobei der Film aus Partikeln, welcher in Schritt a) gebildet wird, eine Dicke aufweist, welche zwischen 20 nm und 2 µm beträgt.

9. Verfahren nach einem der Ansprüche 1 bis 8, wobei die innere Fläche der Beschichtung aus Diamant, welche beim Abschluss des Schritts b) erhalten wird, direkt in Kontakt mit der metallischen Oberfläche des zu schützenden Gegenstands ist.

10. Gegenstand (1), umfassend ein metallisches Substrat, welches eine Oberfläche aufweist, welche mit einer Beschichtung aus Diamant (2) bedeckt ist, **dadurch gekennzeichnet, dass** die Beschichtung aus Diamant durch das Ausführen des Verfahrens wie in einem der Ansprüche 1 bis 9 definiert erhalten ist.

11. Gegenstand (1) nach Anspruch 10, wobei die Beschichtung aus Diamant auf dem Niveau ihrer äußeren Fläche eine Porosität aufweist, welche kleiner als 0,1% des Gesamtvolumens der Beschichtung aus Diamant ist, und die vorzugsweise null ist.

12. Gegenstand (1) nach Anspruch 10 oder 11, wobei die Beschichtung aus Diamant eine maximale Porosität auf dem Niveau ihrer inneren Fläche aufweist, wobei die maximale Porosität 0,1 bis 10% des Gesamtvolumens der Beschichtung aus Diamant entspricht.

## Claims

1. A method for improving the adhesion of a diamond coating (5) on a metal surface of a part (1), said method comprising the following steps:
a) forming, on the surface to be protected, a film (2) of nanosize diamond particles (3);
b) forming the diamond coating (5) by diamond growth from the nanoparticles (3) of the film (2), the growth being performed by plasma assisted chemical vapour deposition;
the method being **characterised in that**, in the film (2) of nanosize diamond particles (3) obtained in step a), the particles are arranged stacked over each other in a plurality of successive stacking layers (4), the film being obtained by implementing the following operations:
i) contacting the metal surface to be protected with a colloidal solution containing nanosize diamond particles dispersed in a solvent; and
ii) removing the solvent through drying, whereby a stacking layer is obtained;
the series of said operations i) and ii) being repeated several times in succession, preferably at least four times;
and the method being **characterised in that**, in step b), the diamond growth from nanoparticles (3) of the film (2) is performed by plasma assisted chemical vapour deposition under conditions enabling a growth of the nanoparticles from 1 to 20nm, using a pressure between 2 and 30mbar and a temperature of the part to be coated between 200 and 400°C, whereby a diamond coating is obtained, having an inner face and an outer face, and including a porosity gradient (6) increasing from the outer face towards the inner face.

2. The method according to claim 1, wherein step a) further comprises, before operation i), an operation h) of depositing, on the surface to be protected, a layer of a positively or negatively charged polymer, and operation i) consists in contacting the layer of polymer with a colloidal solution containing nanosize diamond particles having an electric charge opposite to the one of the polymer and which are dispersed in a solvent, the series of operations h), i) and ii) being repeated several times in succession, preferably at least four times.

3. The method according to claim 1 or claim 2, wherein step a) further comprises, after operation ii) of removing the solvent, and before the repetition of the series of operations i) and ii), an operation of diamond growth from the nanoparticles (3) of the stacking layer obtained at the end of operation ii), the growth being performed by plasma assisted chemical vapour deposition under conditions enabling a partial coalescence of the nanoparticles of said stacking layer to be obtained.

4. The method according to claim 3, wherein the operation of diamond growth in step a) is performed at a pressure between 2 and 30mbar and at a temperature of the part to be coated between 200 and 400°C.

5. The method according to any of claims 1 to 4, wherein the diamond coating obtained at the end of step b) has, at its outer face, a porosity lower than 0.1% of the total volume of the diamond coating, and which is preferably zero.

6. The method according to any of claims 1 to 5, wherein the diamond coating obtained at the end of step b) has a maximum porosity at its inner face, said maximum porosity corresponding to 0.1 to 10% of the total volume of the diamond coating.

7. The method according to any of claims 1 to 6, wherein the film of particles formed in step a) includes at least four stacking layers.

8. The method according to any of claims 1 to 7, wherein the film of particles formed in step a) has a thickness between 20nm and 2µm.

9. The method according to any of claims 1 to 8, wherein the inner face of the diamond coating obtained at the end of step b) is directly in contact with the metal surface of the part to be protected.

10. A part (1) including a metal substrate having a surface covered with a diamond coating (2), **characterised in that** the diamond coating is obtained by implementing the method such as defined in any of claims 1 to 9.

11. The part (1) according to claim 10, wherein the diamond coating has, at its outer face, a porosity lower than 0.1% of the total volume of the diamond coating, and which is preferably zero.

12. The part (1) according to claim 10 or 11, wherein the diamond coating has a maximum porosity at its inner face, said maximum porosity corresponding to 0.1 to 10% of the total volume of the diamond coating.
